# EUROPEAN PATENT APPLICATION

(11) **EP 4 807 823 A1**
(43) Date of publication of application: **16.09.2026**
(21) Application number: 25163245.1
(22) Date of filing: 12.03.2025
(51) Int. Cl.: H01M 8/04014, B60L 58/26, B60L 58/27, B60L 58/33, B60L 58/34, H01M 10/48, H01M 10/613, H01M 10/615, H01M 10/617, H01M 10/625, H01M 10/6563, H01M 8/0432, H01M 8/04701, H01M 10/63, H01M 10/6556

(54) **THERMAL MANAGEMENT SYSTEM FOR AN ENERGY STORAGE SYSTEM (ESS) OF A VEHICLE**

(71) Applicant: Volvo Truck Corporation, 405 08 Göteborg (SE)
(72) Inventor: V, Sri Gokulnath, 642126 Udumalpet (IN); Nair, Aiswarya, 691536 Kadakkal (IN); Y, Prakash, 560046 Bangalore (IN)
(74) Representative: Zacco Sweden AB

(57) **Abstract**

A thermal management system for an energy storage system (ESS) of a vehicle includes at least one ESS; and at least one duct in thermal contact to the at least one ESS, wherein the at least one duct is internally shaped to heat incoming air when the vehicle is in motion.

## Description

### TECHNICAL FIELD

The disclosure relates generally to a thermal management system. In particular aspects, the disclosure relates to a thermal management system for an energy storage system (ESS) of a vehicle. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Many vehicle manufacturers have increased production of battery electric vehicles (BEVs). Many BEVs use lithium ion batteries. Lithium ion battery efficiency is typically a function of temperature, especially when the temperatures of the battery is outside of an optimal range, e.g., 10-40 degrees Celsius. As such, environmental temperatures can significantly impact lithium ion battery efficiency and related characteristics, such as vehicle driving range, battery lifespan, fire risk, etc. For example, driving range for BEVs may be reduced (e.g., greater than 30%) when they are operating in colder environments (e.g., Scandinavia where the average temperature is around -15 degrees Celsius) or hotter environments (e.g., equatorial regions or mining areas where the average temperature is around 40 degrees Celsius). There is a need for a technical solution for keeping the temperature of an ESS within an optimal range.

### SUMMARY

According to a first aspect of the disclosure, a thermal management system for an energy storage system (ESS) of a vehicle including at least one ESS. The thermal management system further includes at least one duct in thermal contact to the at least one ESS, wherein the at least one duct is internally shaped to heat incoming air when the vehicle is in motion. The first aspect of the disclosure may seek to improve thermal management systems by reducing energy consumption, especially in comparison to a thermal management system having an electric heater. A technical benefit may include an increased driving range and increased battery lifespan for the ESS, as the thermal management system consumes less energy than an electric heater integrated thermal management system.

Optionally in some examples, including in at least one preferred example, the at least one duct includes a heating channel. The heating channel includes an acceleration region. The acceleration region includes a first inlet and a first convergent section downstream of the first inlet to accelerate air coming via the first inlet. The heating channel further includes a primary heating region. The primary heating region includes a first divergent section downstream of first convergent section and a second convergent section downstream of divergent to build pressure upstream and accelerate air to hypersonic speed downstream. The heating channel further includes a secondary heating region. The secondary heating region includes a throat section downstream of second convergent section to heat walls of the duct and to facilitate heat exchange of the air and an outlet downstream of the throat section.

Optionally in some examples, including in at least one preferred example, a first cross sectional area of the first inlet is larger than a second cross sectional area of the first convergent section; a third cross sectional area of the first divergent section is larger than the second cross sectional area of the first convergent section; and a fourth cross sectional area of the throat section is smaller than the second cross sectional area of the first convergent section.

Optionally in some examples, including in at least one preferred example, the at least one duct includes a cooling channel. The cooling channel includes a second acceleration region. The second acceleration region includes a second inlet and a fourth convergent section downstream of the second inlet to accelerate air coming via the second inlet. The cooling channel further includes a low pressure region downstream of the fourth convergent section. The cooling channel further includes an expansion region. The expansion region includes a second divergent section downstream of the low pressure region to facilitate expansion, resulting in a temperature decrease of the air.

Optionally in some examples, including in at least one preferred example, the thermal management system includes at least one shutter positioned upstream of the at least one duct to selectively control air flow through the at least one duct. The thermal management system further includes a controller for controlling the at least one shutter.

Optionally in some examples, including in at least one preferred example, the at least one duct includes at least one heating channel and at least one cooling channel; and the at least one shutter includes at least one hole. The shutter is adjustable between a first position to align the at least one hole with the at least one cooling channel to allow air flow through the at least one cooling channel and a second position to align the at least one hole with the at least one heating channel to allow air flow through the at least one heating channel.

Optionally in some examples, including in at least one preferred example, the first position further blocks the at least one heating channel to restrict air flow through the heating channel and the second position further blocks the at least one cooling channel to restrict air flow through the cooling channel.

Optionally in some examples, including in at least one preferred example, the controller moves the at least one shutter to the first position based on a first temperature and the controller moves the at least one shutter to the second position based on a second temperature.

Optionally in some examples, including in at least one preferred example, the at least one duct includes an equal number of cooling channels and heating channels in an alternating pattern.

Optionally in some examples, including in at least one preferred example, the at least one duct includes a side duct in thermal contact with a side wall of the at least one ESS. The side duct includes at least one cooling channel and at least one heating channel. The at least one duct further includes a bottom duct in thermal contact with a bottom wall of the at least one ESS. The bottom duct includes at least one cooling channel and at least one heating channel.

Optionally in some examples, including in at least one preferred example, the controller includes a control chamber. The control chamber includes a diaphragm and a plunger. The plunger moves the at least one shutter in response to a change in density of a heat sensing fluid. The controller further includes at least one heat sensing unit in thermal contact with the at least one ESS. The at least one heat sensing unit includes an enclosure for storing the heat sensing fluid. The controller further includes at least one connection pipe to allow the heat sensing fluid to move between the at least one heat sensing unit and the control chamber in response to the change in density of the heat sensing fluid triggered by temperature changes of the at least one ESS.

Optionally in some examples, including in at least one preferred example, the at least one ESS includes a battery.

Optionally in some examples, including in at least one preferred example, the at least one ESS includes a fuel cell.

Optionally in some examples, including in at least one preferred example, the at least one ESS includes a plurality of ESS and the at least one heat sensing unit includes a plurality of heat sensing units. Each of the plurality of heat sensing units is in thermal contact with a respective ESS. At least one connection pipe interconnects the plurality of heat sensing units and the control chamber to facilitate movement of the heat sensing fluid in response to temperature changes across the plurality of ESS.

Optionally in some examples, including in at least one preferred example, the control chamber includes a spring for facilitating returning the plunger back to a neutral starting position.

Optionally in some examples, including in at least one preferred example, the heat sensing fluid is selected from a group consisting of freon, ammonia, an alcohol, hydrocarbons, a fluoridated liquid, a gallium alloy, a thermal oil, and carbon dioxide.

Optionally in some examples, including in at least one preferred example, the heat sensing unit, the at least one duct, the connection pipe, and/or the control chamber is constructed from a thermally conductive material.

Optionally in some examples, including in at least one preferred example, the thermally conductive material includes at least one of copper, silver, or aluminum.

Optionally in some examples, including in at least one preferred example, density of the heat sensing fluid and temperature of the at least one ESS is inversely proportional.

According to a second aspect of the disclosure, a method for performing thermal management for an ESS of a vehicle includes detecting, using a controller and a heat sensing fluid, changes in temperature of at least one ESS. The method further includes actuating, by the controller, a shutter positioned upstream of a duct to selectively control air flow through the duct, wherein the duct is in thermal contact with the at least one ESS, wherein the duct is internally shaped to heat incoming air when the vehicle is in motion. The second aspect of the disclosure may seek to improve thermal management systems by reducing energy consumption, especially in comparison to a thermal management system having an electric heater. A technical benefit may include an increased driving range and increased battery lifespan for the ESS, as the thermal management system consumes less energy than an electric heater integrated thermal management system.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
FIG. 1 illustrates an example of a conventional thermal management system for an energy storage system (ESS) of a vehicle, according to the prior art.
FIG. 2 is an exemplary perspective view of operation of a thermal management system for an ESS comprising ducts for passively heating incoming air, according to an example.
FIG. 3 is an exemplary perspective view of a thermal management system for an ESS comprising ducts with shutters, according to an example.
FIG. 4A is an exemplary perspective view of the side duct of FIG. 3, according to an example.
FIGS. 4B and 4C are exemplary perspective views of the shutter at different positions in relation to the side duct of FIG. 4A, according to an example.
FIG. 5 is an exemplary sectional view of operation of a heating channel of FIG. 4, according to an example.
FIG. 6 is an exemplary sectional view of operation of a cooling channel of FIG. 4, according to an example.
FIG. 7 is an exemplary perspective view of a shutter control system, according to an example.
FIGS. 8A and 8B are exemplary isometric and sectional views of a side controller of FIG. 3, according to an example.
FIG. 9 is a flow chart of operations 900 of an exemplary method for performing thermal management for an ESS of a vehicle, according to an example.

### DETAILED DESCRIPTION

The detailed description set forth below provides information and examples of the disclosed technology with sufficient detail to enable those skilled in the art to practice the disclosure.

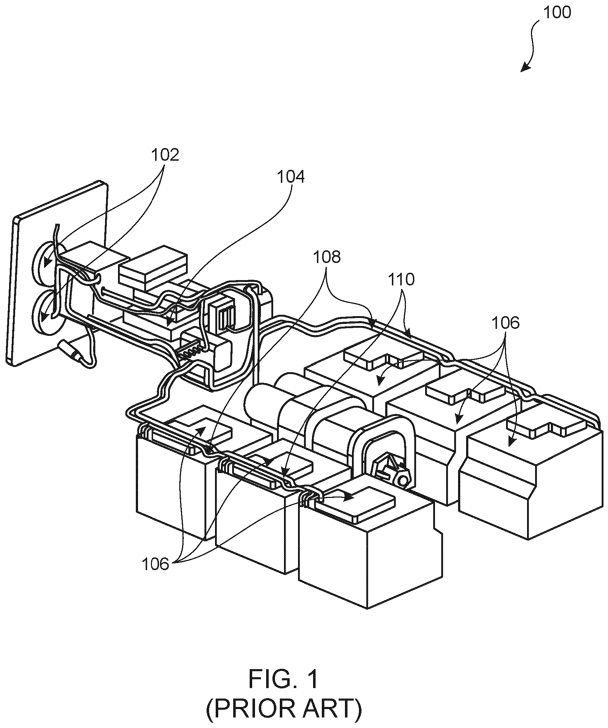

FIG. 1 illustrates an example of a conventional thermal management system 100 for an energy storage system (ESS) of a vehicle, as known in the prior art. The thermal management system 100 is designed to regulate the temperature of ESS batteries 106 and can use coolant or fluid to manage the temperature of ESS batteries 106. The thermal management system 100 includes a coolant regulator 104 to actively manage coolant within the system. Coolant circulates via supply lines 108 to the ESS batteries 106 and return lines 110 from the ESS batteries 106, forming a closed-loop configuration controlled by the coolant regulator 104. Depending on needs, the coolant regulator 104 may use heat exchangers and fans to cool the coolant or electric heaters to heat the coolant. Pumps can ensure consistent coolant flow throughout the system, while valves can selectively route the coolant to different sections as required. Sensors may be used to monitor temperature, flow rate, and pressure, and may provide feedback for thermal management.

The thermal management system 100 draws energy from the ESS batteries 106 to power its components and may consume significant amounts of energy (e.g., 5 kW or more in some examples) to maintain the batteries at an optimal temperature, depending on the environmental conditions. This energy demand can significantly impact the vehicle's driving range, highlighting some tradeoffs of conventional thermal management systems.

In some embodiments, a thermal management system for an ESS of a vehicle utilizes less energy than the thermal management system 100 (e.g., by eliminating electric heater or other electrical components) and, as such, may increase the driving range of the ESS relative to the thermal management system 100.

In some embodiments, a thermal management system may include one or more ducts that are internally shaped to heat incoming air when the vehicle is in motion. In some embodiments, at least one duct or a heating channel therein may include an acceleration region, a primary heating region, and a secondary heating region. The acceleration region may include a first inlet and a first convergent section downstream of the first inlet to accelerate air coming via the first inlet. The primary heating region may include a first divergent section downstream of first convergent section and a second convergent section downstream of divergent to build pressure upstream and accelerate air to hypersonic speed downstream. The secondary heating region may include a throat section downstream of second convergent section to heat walls of the duct and to facilitate heat exchange with the air and an outlet downstream of the throat section.

As used herein, unless indicated otherwise, the terms "downstream" and "upstream" relate to the direction air traverses a respective duct or a channel therein, e.g., a heating channel. In other words, when a first region is described as downstream of a second region, the first region is closer to the outlet than the second region and when a first region is described as upstream of a second region, the first region is closer to the inlet than the second region.

In some embodiments, a thermal management system may include at least one shutter positioned upstream of at least one duct to selectively control air flow through the at least one duct and a controller for controlling the at least one shutter.

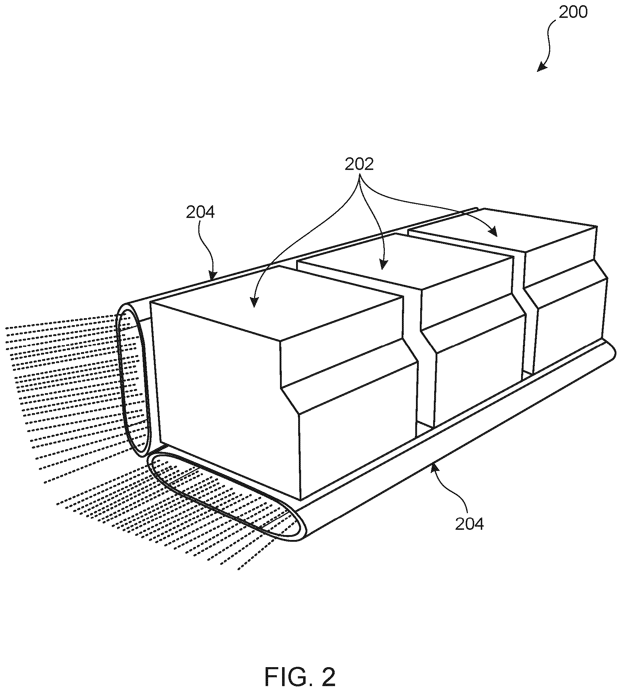

In this regard, FIG. 2 is an exemplary perspective view of operation of a thermal management system 200 for an ESS 202 (e.g., one or more batteries or fuel cells) comprising ducts 204 for passively heating incoming air, according to an example. Each of the ducts 204 may be internally shaped (e.g., the internal geometry of each duct, such as a convergent section followed by a divergent section followed by a throat section as will be described in greater detail below) to heat incoming air when the vehicle is in motion. Each of the ducts 204 may be in thermal contact with the ESS 202 (e.g., touching a wall or side of the ESS 202 or a component thereof). For example, as depicted in FIG.2, one of the ducts 204 may be mounted on one side of the ESS 202, while another one of the ducts 204 may be mounted on the underside or bottom of the ESS 202. As such, heat generated inside the ducts 204 (e.g., due to airflow traversing the ducts 202 when the vehicle is in motion) can be transferred to the ESS 202, thereby warming or heating the ESS 202.

In some embodiments, air may enter each of the ducts 204 (e.g., with a velocity of 2 meters per second (m/s)) via one end (e.g., an inlet) and exits an opposite end (e.g., an outlet) when the vehicle is moving forward and the air may be heated by the internal shape or geometry of the ducts 204 or sections therein. In some embodiments, the internal shape or geometry of the ducts 204 may help increase the temperature around and/or of the ESS 202, e.g., when air enters ducts 204 with a certain flow rate, by using convergent and divergent sections. In some embodiments, after traversing a convergent section to increase the velocity of air particle, an increase in area of a duct cross section (e.g., at a subsequent divergent section) may decrease the velocity of air particles which in turn increases the pressure and contributes to increases in temperature of air.

Simulation studies has been done with examples of a duct described herein with the following conditions: ambient air at -15 degrees Celsius enters the duct with a velocity of 2m/s. Results from the simulation studies indicate that temperature from the duct (via the airflow) allows heat transfers to an ESS that are significantly higher (e.g., 25 degrees Celsius) than the original starting temperature of the air. Furthermore, the results indicates that the effectiveness of the internally-shaped ducts can be adjusted to suit requirements, e.g., effectiveness can be advanced (prior to 20kmph) (or) delayed ( above 20 kmph) based on the requirement by adjusting the convergent and divergent ratio at various sections.

In some embodiments, when a vehicle is moving forward, air particles (e.g., at a temperature of -15 degrees Celsius) may flow into a duct via an inlet and pass through an acceleration region, where their velocity increases due to a first convergent section of the duct, consistent with Bernoulli's principle.

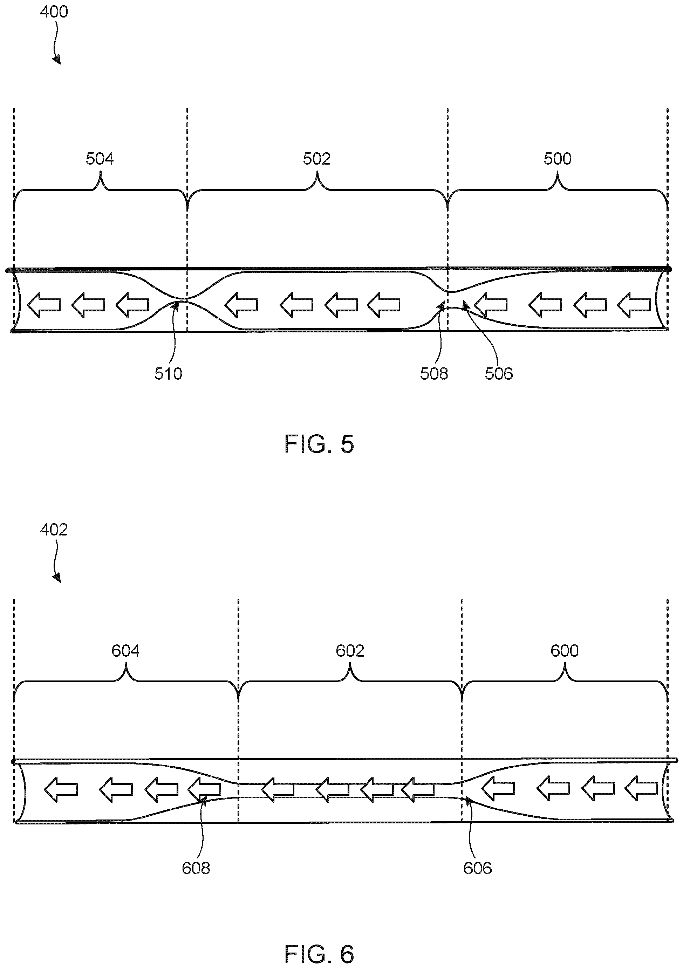

In some embodiments, e.g., after leaving a primary heating region of a duct, air particles may enter a secondary heating region of the duct through a second divergent section of the duct. As these air particles move with significant velocity and interact with the walls of the secondary heating region, they release heat energy (e.g., the temperature of the walls of the secondary heating region may be notably warmer than the outside air, such as 5 degrees Celsius instead of -15 degrees Celsius). After extracting the heat from the air particles both in primary heating region as well as the secondary heating, the air particles may exit the air duct, e.g., via an outlet. As will be discussed in greater detail with respect to FIG. 5 below, after entering a primary heating region via a first divergent section of the duct, the high velocity air particles may hit the walls of a second convergent section (e.g., a throat section) of the duct downstream. In response to the high velocity air particles hitting the walls of the second convergent section, the pressure of the air particles will increase since pressure is directly proportional to temperature per the ideal gas equation (e.g., *pV* = *nRT,* where *and* ence, the temperature of the air particles increases and heat energy is transferred to the walls of the air duct (e.g., the temperature of the walls of the primary heating region may be significantly warmer than the outside air, such as 25 degrees Celsius instead of -15 degrees Celsius) and this heat can be transferred to the ESS 202, thereby warming the ESS 202.

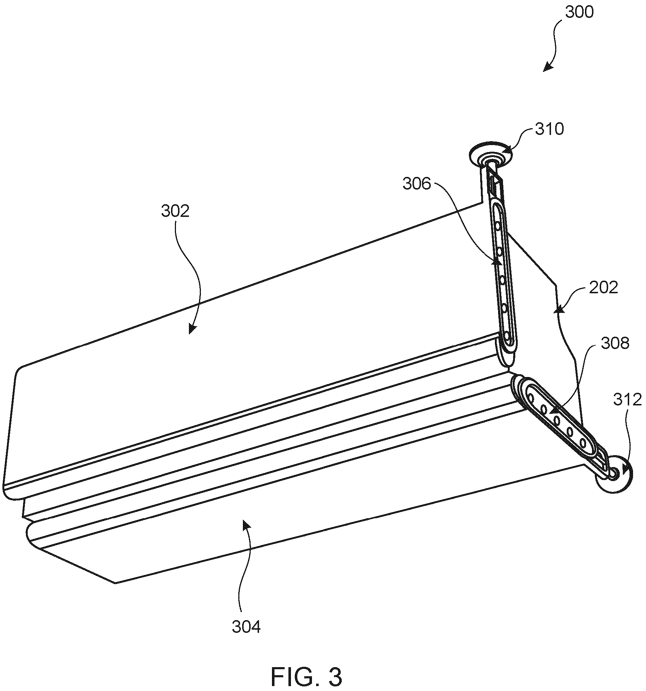

FIG. 3 is an exemplary perspective view of a thermal management system 300 for an ESS 202 comprising ducts with shutters, according to an example. The thermal management system comprises two ducts, a side duct 302 and a bottom duct 304. The side duct 302 is in thermal contact with (e.g., mounted on) a side or side wall of the ESS 202. The side shutter 306 is positioned upstream (e.g., at or in front of an inlet) of the side duct 302. The side shutter 306 can selectively control air flow through the side duct 302 using a controller 310. The bottom duct 304 is in thermal contact with (e.g., mounted on) a bottom or underside of the ESS 202. The bottom shutter 308 is positioned upstream (e.g., at or in an inlet) of the bottom duct 304. The bottom shutter 308 can selectively control air flow through the bottom duct 304 using a controller 312.

In some embodiments, each of the controllers 310 and 312 may be a mechanically operated device to control a respective shutter, e.g., thereby changing flow path of air between duct channels. In some examples, each of the controllers 310 and 312 may be part of a shutter control system that passively (e.g., mechanically) determines the position of a respective shutter based on the temperature of the ESS (e.g., using a heat sensing fluid). In some examples, each of the controllers 310 and 312 may move (e.g., using an actuator or a plunger) a respective shutter to a first position based on a first temperature and may move the respective shutter to a second position based on a second temperature.

In some embodiments, each of the ducts 302 and 304 may include a plurality of heating channels. In some embodiments, each of the shutters 306 and 308 may include a plurality of holes, with each hole corresponding to a respective heating channel of the plurality of heating channels. In some examples, each of the shutters 306 and 308 may be adjustable between a first position (e.g., an "off" or "low heat" position) to align zero or more of a plurality of holes with zero or more of the plurality or heating channels and a second position (e.g., an "on" or "high heat" position) to align more holes of the plurality of holes with more of the plurality of heating channels than in the first position.

In some embodiments, each of the ducts 302 and 304 may include different types of channels, e.g., heating channels to heat the ESS 202 and cooling channels to cool the ESS 202. In some embodiments, each of the shutters 306 and 308 may include holes corresponding to at least channels of a respective duct. In some examples, each of the shutters 306 and 308 may be adjustable between a first position to align the at least one hole with the at least one cooling channel to allow air flow through the at least one cooling channel and a second position to align at least one hole with at least one heating channel to allow air flow through the at least one heating channel.

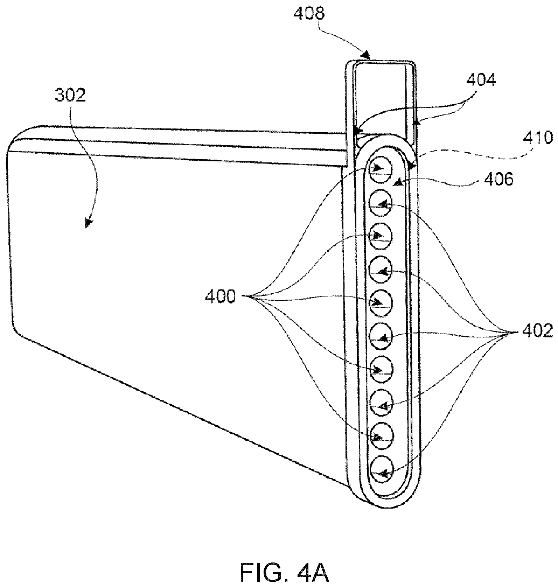

FIG. 4A is an exemplary perspective view of the side duct 302 of FIG. 3, according to an example. The side duct 302 may include heating channels 400 to heat the ESS 202 and cooling channels 402 to cool the ESS 202. Simulation results for the heating channels 400 indicate that under initial conditions of -15 degrees Celsius air temperature, 1 atmosphere (atm) air pressure, and a vehicle velocity of 20 kilometers per hour (km/h), each of the heating channels 400 can increase the air temperature by up to 10 degrees Celsius, demonstrating effective performance even in cold atmospheric conditions. Simulation results for the cooling channels 402 indicate that under initial conditions of 40 degrees Celsius air temperature, 1 atm air pressure, and a vehicle velocity of 40 km/h, the cooling channel can effectively maintain the channel wall temperature at 10 degrees Celsius, demonstrating effective performance even in hot atmospheric conditions.

The side duct 302 may include or be in contact with a faceplate 406 comprising holes aligned with the channels 400 and 402. The faceplate 406 may be positioned upstream (e.g., at or in front of an inlet) of the side duct 302. In some embodiments, the faceplate 406 may be positioned upstream of the side shutter 306. In some embodiments, the side walls 404 and the faceplate 406 may be part of a shutter assembly 408 to support the side shutter 306 and/or facilitate the movement of the side shutter 306. In some embodiments, the shutter assembly 408 may include slots or tracks (e.g., an optional centered channel or groove 410 on the inside of each of the side walls 404 of the shutter assembly 408) to support the side shutter 306 in one or more positions and may include struts or other structural elements to secure the side controller 310.

In some embodiments, the heating channels 400 and the cooling channels 402 may be in various arrangements. In some examples, e.g., as depicted in FIG. 4A, the side duct 302 may include 10 channels, with five heating channels 400 and five cooling channels 402 arranged in alternating patterns,. For example, the heating channels 400 and the cooling channels 402 may alternate from top to bottom beginning with one of the heating channels 400, e.g., a first heating channel 'H1', a first cooling channel 'C1', a second heating channel 'H2', a second cooling channel 'C2', etc. In another example, the heating channels 400 and the cooling channels 402 may alternate from top to bottom beginning with one of the cooling channels 402, e.g., a first cooling channel 'C1', a first heating channel 'H1', a second cooling channel 'C2', a second heating channel 'H2', etc.

In some examples, the side shutter 306 may be adjustable (e.g., by the side controller 310) between a first position to align the at least one shutter hole(s) with faceplate hole(s) corresponding to at least one of the heating channels 400 to allow air flow through the at least one heating channel and a second position to align the at least one shutter hole(s) with faceplate hole(s) corresponding to at least one of the cooling channels 402 to allow air flow through the at least one cooling channel. In some examples, in the first position, the side shutter 306 is configured to open the cooling channels 402 and block the heating channels 400. In some examples, in the second position, the side shutter 306 is configured to open the heating channels 400 and block the cooling channels 402. In some examples, the first position may block all of the heating channels 400 while allowing air flow through all of the cooling channels 402, and the second position may block all of the cooling channels 402 while allowing air flow through all of the heating channels 400.

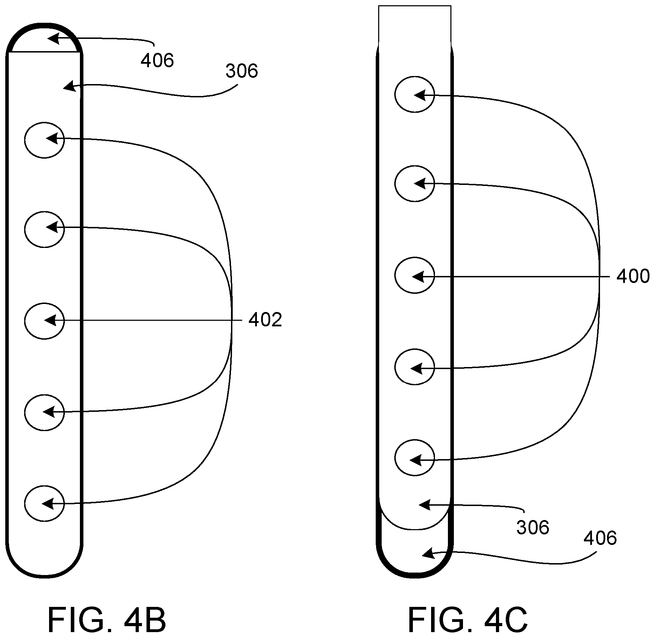

Referring to FIGS. 4B and 4C, FIG. 4B is a diagram depicting the side shutter 306 in an example first position in relation to the faceplate 406 of the side duct 302 and FIG. 4C is a diagram depicting the side shutter 306 in an example second position in relation to the faceplate 406 of the side duct 302.

In FIG. 4B, the holes of the side shutter 306 are aligned with the inlets of the cooling channels 402 while the rest of the side shutter 306 blocks or covers the inlets of the heating channels 400. As depicted in FIG. 4B, the first position of the side shutter 306 may allow air to flow through the cooling channels 402 while blocking or restricting air flow through the heating channels 400. In some examples, the side shutter 306 may be moved (e.g., by controller 310) to the first position from the second position (e.g., depicted in FIG. 4C).

In FIG. 4C, the holes of the side shutter 306 are aligned with the inlets of the heating channels 402 while the rest of the side shutter 306 blocks or covers the inlets of the cooling channels 402. As depicted in FIG. 4C, the second position of the side shutter 306 may allow air to flow through the heating channels 400 while blocking or restricting air flow through the cooling channels 402. In some examples, the side shutter 306 may be moved (e.g., by controller 310) to the second position from the first position (e.g., depicted in FIG. 4A).

In this example, the side shutter 306 may be configured to automatically move between the first position and the second position to maintain the ESS 202 in a desired temperature range. That is, the side shutter 306 may be moved to the first position (i.e., the cooling mode) in response to the temperature of the ESS 202 reaching a first temperature, and may remain in the first position indefinitely until the temperature of the ESS 202 reaches a second lower temperature, at which point the side shutter 306 is moved to the second position (i.e., the heating mode), where it likewise may remain indefinitely until the temperature of the ESS 202 rises to the first temperature, and so on. In this manner, the temperature of the ESS 202 may be maintained between the first and second temperatures.

In some embodiments, a shutter (e.g., the side shutter 306) may be movable to additional positions other than a first position and a second position, e.g., a third position. For example, a third position may result in at least one heating channel and at least one cooling channel being opened (e.g., to allow air flow through the channels). In another example, a third position may result in at least one heating channel and at least one cooling channel being closed (e.g., to stop or restrict air flow through the channels). In some embodiments, the third position may represent a "neutral" position and may be designed or configured to have a neutral or reduced effect on the temperature of the ESS 202.

It will be appreciated that the labels (e.g., "first", "second", etc.) for shutter positions in FIGS. 4A-4C (and elsewhere) are illustrative. It will also be appreciated that while FIGS. 4A-4C refer to various aspects and embodiments related to controlling the side shutter 306 to effect air flow through the side duct 302, these or similar aspects and embodiments are applicable for controlling the bottom shutter 308 to effect air flow through the bottom duct 304. It will also be appreciated that the order and/or arrangement of the various channels in the respective duct and the shape or design of the respective shutter can affect whether a particular shutter position will have a cooling effect or a heating effect.

FIG. 5 is an exemplary sectional view of operation of a heating channel 400 of FIG. A, according to an example. As shown in FIG. 5, air can enter the heating channel 400 through an inlet and pass through various regions of the heating channel 400, including an acceleration region 500, a primary heating region 502, and a secondary heating region 504, before exiting via an outlet.

As used herein, unless indicated otherwise, the terms "downstream" and "upstream" relate to the direction air traverses a respective duct (or channel therein), e.g., the heating channel 400. In other words, when a first region is described as downstream of a second region, the first region is closer to the outlet of the duct (or channel) than the second region and when a first region is described as upstream of a second region, the first region is closer to the inlet of the duct (or channel) than the second region.

In some embodiments, when air enters the heating channel 400 via an inlet, the velocity of the air increases in the acceleration region 500. The high-velocity air then flows into the primary heating region 502, where the pressure is increased by choking the flow at a throat section 510 downstream. According to the ideal gas equation, the pressure increase results in a corresponding rise in temperature. Consequently, the walls of the primary heating region 502 heat up. Furthermore, the high-pressure air exits the throat section 510 at a high velocity, generating additional heat due to viscous drag between the air and the walls of the secondary heating region 504, thereby facilitating extraction of additional heat in the secondary heating region.

Referring to FIG. 5, the acceleration region 500 is a portion of the heating channel 400 downstream of the inlet of the heating channel 400. The acceleration region 500 may be usable to accelerate incoming air (e.g., from the inlet of the side duct 302) using a convergent section 506, consistent with Bernoulli's principle. The convergent geometry of the convergent section 506 facilitates a controlled decrease in the cross-sectional area, increasing the velocity of the air and causing the pressure to drop in accordance with Bernoulli's principle. In some embodiments, aspects (e.g., geometry, texture, length, degree, slope, etc.) of the convergent section 506 may be based on requirements, research, and/or simulation results, e.g., predicted usage environments, manufacturer or user preferences, and predetermined values. In some examples, a downstream-most point (e.g., the narrowest point) of the convergent section 506 may be made or constructed to have a cross sectional area that is a percentage (e.g., 75%) smaller than the inlet of the heating channel 400.

In some embodiments, the primary heating region 502 is a portion of the heating channel 400 downstream of the acceleration region 500 of the side duct 302. The primary heating region 502 may be usable to facilitate heat transfer to the ESS 202 and may include a divergent section 508 to decrease the velocity of the air coming from the acceleration region 500 (while causing a corresponding increase in pressure) and a second convergent section further downstream, to choke the air flow, thereby causing pressure and temperature to rise in the primary heating region 502 and heating the walls of the primary heating region 502. The divergent geometry of the divergent section 508 facilitates a controlled increase in the cross-sectional area. In some embodiments, aspects (e.g., geometry, texture, length, degree, slope, etc.) of the divergent section 508 may be based on requirements, research, and/or simulation results, e.g., predicted usage environments, manufacturer or user preferences, and predetermined values. In some examples, a downstream-most point (e.g., the widest point) of the divergent section 508 may be made or constructed to have a cross sectional area that is a percentage (e.g., 300%) larger than the downstream-most point of the convergent section 506 but no larger than the cross sectional area of the inlet of the heating channel 400.

In some embodiments, the secondary heating region 504 is a portion of the heating channel 400 downstream of the primary heating region 502 of the side duct 302. The secondary heating region 504 may be usable to facilitate heat transfer to the ESS 202 and may include a throat section 510 representing a downstream-most point (e.g., the narrowest point) of a second convergent section (e.g., a portion of which may be in the primary heating region 502). In some embodiments, the second convergent section, including the throat section 510, is usable to choke the air flow, thereby causing pressure and temperature to rise in the primary heating region 502 and heating the walls of the primary heating region. The throat section 510 is also usable to facilitate high pressure air to exit the throat section 510 (e.g., via a second divergent section located in the secondary heating region 504) which causes more heat energy in the secondary heating region 504, e.g., due to viscous drag between the air and the walls of the secondary heating region 504. In some embodiments, aspects (e.g., geometry, texture, length, degree, slope, etc.) of the throat section 510 (and its surrounding convergent and divergent sections) may be based on requirements, research, and/or simulation results, e.g., predicted usage environments, manufacturer or user preferences, and predetermined values. In some examples, the throat section 510 may be made or constructed to have a cross sectional area that is a percentage (e.g., 80%) smaller than the downstream-most point of the convergent section 506.

FIG. 6 is an exemplary sectional view of operation of a cooling channel 402 of FIG. 4A, according to an example. As shown in FIG. 6, air can enter the cooling channel 402 through an inlet and pass through various regions of the channel, including an acceleration region 600, a low-pressure region 602, and an expansion region 604, before exiting via an outlet.

In some embodiments, when air enters the cooling channel 402, the velocity of the air increases due to a convergent section 606 in the acceleration region 600. The increased velocity causes a reduction in the pressure of the air. The low-pressure, high-velocity air may flow through the low-pressure region 602 and then the air may expand in the expansion region 604. During expansion, the temperature of the air drops, causing heat from the ESS 202 to transfer to the air through the walls of the cooling channel 402, e.g., since heat generally flows from higher to lower temperatures, thereby reducing the temperature of the ESS 202.

Referring to FIG. 6, the acceleration region 600 is a portion of the cooling channel 402 downstream of the inlet of the cooling channel 402. The acceleration region 600 may be usable to accelerate incoming air (e.g., from the inlet of the side duct 302) using a convergent section 606. The convergent geometry of the convergent section 606 facilitates a controlled decrease in the cross-sectional area, increasing the velocity of the air and causing the pressure to drop in accordance with Bernoulli's principle. In some embodiments, aspects (e.g., geometry, texture, length, degree, slope, etc.) of the convergent section 606 may be based on requirements, research, and/or simulation results, e.g., predicted usage environments, manufacturer or user preferences, and predetermined values. In some examples, a downstream-most point (e.g., the narrowest point) of the convergent section 606 may be made or constructed to have a cross sectional area that is a percentage (e.g., 75%) smaller than the inlet of the cooling channel 402.

The low pressure region 602 is a portion of the cooling channel 402 downstream of the acceleration region 600. The low pressure region 602 may be usable to sustain reduced pressure levels to facilitate efficient airflow into the expansion region 604. In some embodiments, aspects (e.g., geometry, texture, length, degree, slope, etc.) of the low pressure region 602 may be based on requirements, research, and/or simulation results, e.g., predicted usage environments, manufacturer or user preferences, and predetermined values. In some examples, the low pressure region 602 may be made or constructed to have a cross sectional area that is the same as the downstream-most point (e.g., the narrowest point) of the convergent section 606.

The expansion region 604 is a portion of the cooling channel 402 downstream of the low pressure region 602. The expansion region 608 may be usable to allow the air to expand as it flows through using a divergent section 608. The divergent geometry of the divergent section 608 facilitates a controlled increase in the cross-sectional area, reducing the velocity of the air and allowing the pressure to recover partially while causing the temperature of the air to drop. This temperature drop enhances heat transfer from the ESS 202 to the air via the walls of the cooling channel 402, improving thermal management performance.

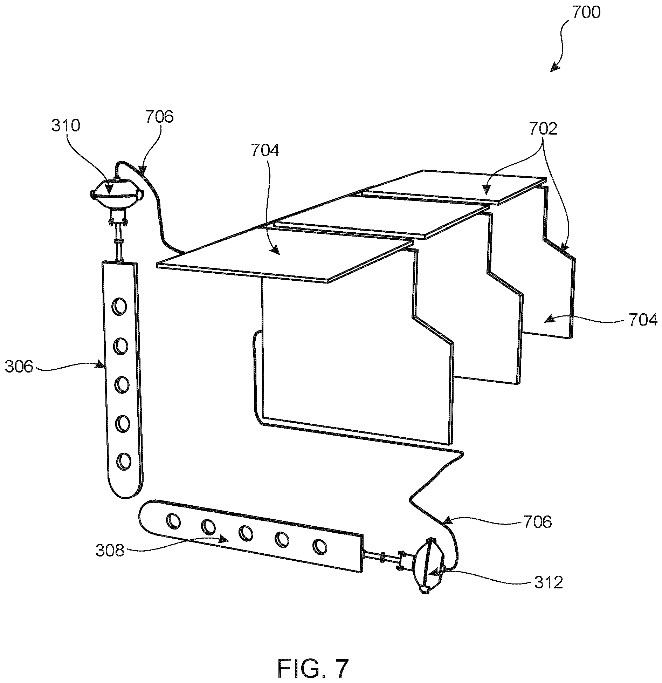

FIG. 7 is an exemplary perspective view of a shutter control system 700, according to an example. The shutter control system 700 may comprise components to control the shutters 306 and 308 utilizing controllers 310 and 312, respectively, without requiring external power. In some embodiments, the shutter control system includes one or more heat sensing units 702. Each of the heat sensing units 702 may be in thermal contact with the ESS 202 (or a portion thereof) and may comprise an enclosure for storing heat sensing fluid, e.g., a fluid with adequate thermodynamic properties such as freon, ammonia, an alcohol, hydrocarbons, a fluoridated liquid, a gallium alloy, a thermal oil, and carbon dioxide, etc. In some embodiments, e.g., each of the heat sensing units 702 include two enclosures (e.g., on a top side of the ESS 202 and on another side of the ESS 202), each enclosure may include a reservoir or bulb 704 for storing heat sensing fluid.

In some embodiments, connection pipes 706 may be usable to allow the heat sensing fluid to move between at least one of the heat sensing units 702 and respective controllers (or control chambers thereof), e.g., in response to the change in density of the heat sensing fluid triggered by temperature changes of the ESS 202. In some embodiments, one of the connection pipes may interconnect the heat sensing units 702 and a respective controller (or a control chamber thereof) to facilitate movement of the heat sensing fluid, e.g., in response to temperature changes across the portions of the ESS 202 (e.g., across a multiple battery or fuel cell system). In some embodiments, various components (e.g., the heat sensing units 702, the controller 310 or a chamber thereof, the connection pipes 706, etc.) of the shutter control system 700 may be constructed from or using a thermally conductive material, such as copper, silver, aluminum, etc.

In some embodiments, as the temperature of the ESS 202 increases, the heat will cause the density of the heat sensing fluid to decrease, thereby cause the fluid to move to other portions of the shutter control system, e.g., the controllers 310 and 312, via connection pipes 706. In some embodiments, each of the controllers 310 and 312 may then move (e.g., using an actuator or a plunger) a respective shutter to a first position (e.g., a "heat" position) when a first temperature threshold is reached, as indicated by the heat sensing fluid. Conversely, as the temperature decreases and the density of the heat sensing fluid increases, each of the controllers 310 and 312 may move the respective shutter to a second position (e.g., a "cool" position), corresponding to a lower temperature threshold.

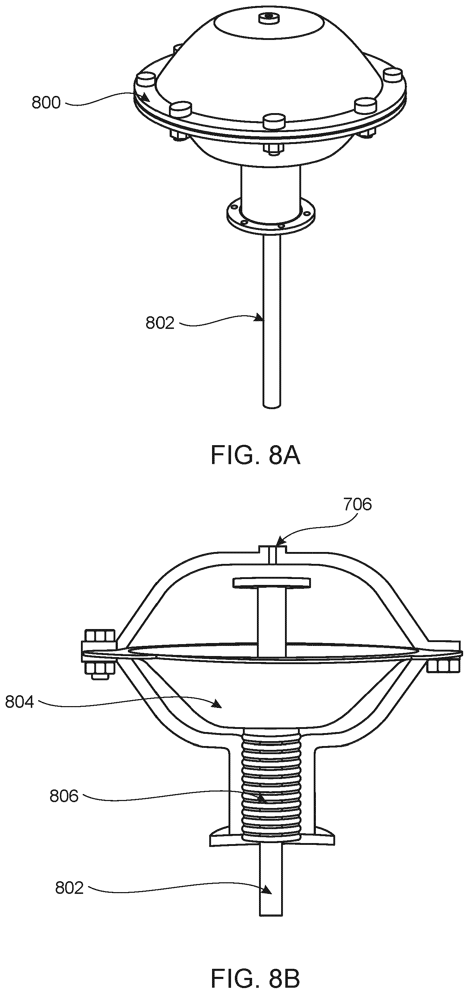

FIGS. 8A and 8B are exemplary isometric and sectional views of the side controller 310 of FIG. 3, according to an example. As shown in FIGS. 8A and 8B, the side controller 310 comprises a control chamber 800. The control chamber may comprise an enclosure capable of holding heat sensing fluid without leaking. The control chamber 800 may include a diaphragm 804 that is movable by heat sensing fluid in response to changes in the density of the heat sensing fluid, which is received via a connection pipe 306 attached to the top of the control chamber 800. The diaphragm 804 is connected to a plunger 802. The plunger 802 may be connected to a shutter, e.g., the side shutter 306. Movement of the diaphragm 804, caused by the heat sensing fluid, may result in the plunger 804 moving the connected shutter to a first position or a second position.

In some embodiments, the diaphragm 804 may be designed to return to a normal or initial state (e.g., a default position) when one or more conditions are met. In some embodiments, the default position may be dependent on various factors, e.g., the arrangement of the heating and cooling channels in an air duct.

In some embodiments, a spring 806 is mounted under the bottom side of the diaphragm 804 and may be usable to return the diaphragm 804 to a normal or initial state (e.g., when the density of the heat sensing fluid is sufficiently decreased). In some embodiments, the diaphragm 804 may be constructed from a spring-like material usable to return the diaphragm 804 to a normal or initial state. In some embodiments, where the diaphragm 804 may be constructed from a spring-like material, the spring 806 may be omitted.

In some examples, when the temperature of the ESS 202 exceeds or meets a first threshold temperature or value (e.g., 30 degrees Celsius), the heat sensing fluid may expand, creating pressure that pushes the diaphragm 804 downward inside the control chamber 800. This downward movement causes the plunger 802 and a connected shutter to move down to a first position, resulting in the closure of the heat channels 400 and the opening of the cooling channels 402. As a result, air may flow through the cooling channels 402, allowing the ESS 202 to be cooled until its temperature decreases to a second threshold temperature or value (e.g., 20 degrees Celsius).

In some examples, when the temperature of the ESS 202 meets or falls below a second threshold temperature or value (e.g., 20 degrees Celsius), the heat sensing fluid may condense, reducing the pressure inside the control chamber 800. This reduction allows the diaphragm 804 to move upward to a second position, assisted by the spring 806 positioned beneath it. In some examples, the spring function can be incorporated directly into the diaphragm material, and may eliminate the need for a separate spring. The upward movement of the diaphragm 804 causes the plunger 802 and the connected shutter to move up, closing the cooling channels and reopening the heat channels. As a result, air may flow through the heating channels, raising the temperature of the ESS 202 until its temperature increases to a first threshold temperature or value (e.g., 30 degrees Celsius).

In some embodiments, by cycling between these states or shutter positions, the shutter control system 700 or controllers thereof can ensure that the ESS temperature is maintained within an optimal range, e.g., within 10 to 40 degrees Celsius. In some embodiments, e.g., when the vehicle is in motion, the shutter control system 700 or controllers thereof can operate automatically and requires no additional energy input, making it highly efficient and self-sustaining.

While FIGS. 8A and 8B and related description above refer to the side controller 306, the bottom controller 308 may include the same or similar components as depicted in FIGS. 8A and 8B. Further, the bottom controller 308 may operate in the same or similar ways as described above with regard to FIGS. 8A and 8B.

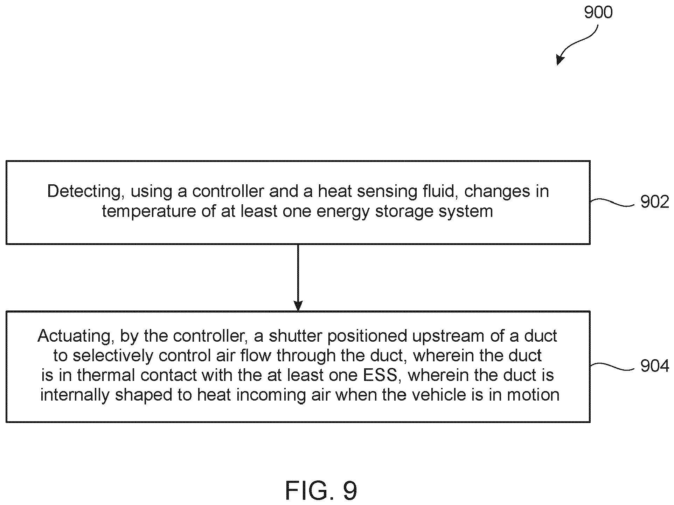

FIG. 9 is a flow chart of operations 900 of an exemplary method for performing thermal management for an energy storage system (ESS) of a vehicle, according to an example.

Referring to FIG. 9, in step 902, changes in temperature of at least one ESS may be detected using a controller and a heat sensing fluid.

In step 904, the controller may actuate a shutter positioned upstream of a duct to selectively control air flow through the duct, wherein the duct is in thermal contact with the at least one ESS, wherein the duct is internally shaped to heat incoming air when the vehicle is in motion.

It will be appreciated that various aspects and values provided herein are for illustrative purposes, as the efficiency of a thermal management system in accordance with various aspects described herein can depend on several factors, including the thermodynamic characteristics of the heat sensing fluid, which can influence fluid behavior under varying temperature conditions; the diameters and cross sectional areas of the convergent and divergent sections, which can affect flow velocity and pressure distribution; the arrangement and sequence of the convergent and divergent sections, which can impact overall airflow performance; the material of the channel walls, which can determine thermal conductivity and influences heat transfer efficiency; the speed of the vehicle, which can directly affects airflow dynamics; and the number of and types of channels, which can affect the system's total heating and cooling capacity. As such, it will be appreciated that by adjusting any of these factors the performance of a thermal management system in accordance with various aspects described herein can be tailored for specific applications.

Additional examples include:
Example 1: A thermal management system for an ESS of a vehicle comprising:
   at least one ESS; and
   at least one duct in thermal contact to the at least one ESS, wherein the at least one duct is internally shaped to heat incoming air when the vehicle is in motion.
Example 2: The thermal management system of example 1, wherein the at least one duct includes a heating channel comprising:
   an acceleration region comprising:
      a first inlet; and
      a first convergent section downstream of the first inlet to accelerate air coming via the first inlet;
   a primary heating region comprising:
      a first divergent section downstream of first convergent section; and
      a second convergent section downstream of divergent to build pressure upstream and accelerate air to hypersonic speed downstream.
Example 3: The thermal management system of example 2, wherein the heating channel further includes:
   a secondary heating region comprising:
   a throat section downstream of second convergent section to heat walls of the duct and to facilitate heat exchange of the air; and
   an outlet downstream of the throat section.
Example 4: The thermal management system of example 3, wherein:
   a first cross sectional area of the first inlet is larger than a second cross sectional area of the first convergent section;
   a third cross sectional area of the first divergent section is larger than the second cross sectional area of the first convergent section; and
   a fourth cross sectional area of the throat section is smaller than the second cross sectional area of the first convergent section.
Example 5: The thermal management system of example 2, wherein the at least one duct includes a cooling channel comprising:
   a second acceleration region comprising:
      a second inlet; and
      a fourth convergent section downstream of the second inlet to accelerate air coming via the second inlet;
   a low pressure region downstream of the fourth convergent section; and
   an expansion region comprising:
      a second divergent section downstream of the low pressure region to facilitate expansion, resulting in a temperature decrease of the air.
Example 6: The thermal management system of example 1, comprising:
   at least one shutter positioned upstream of the at least one duct to selectively control air flow through the at least one duct; and
   a controller for controlling the at least one shutter.
Example 7: The thermal management system of example 6, wherein:
   the at least one duct includes at least one heating channel and at least one cooling channel; and
   the at least one shutter includes at least one hole, wherein the shutter is adjustable between a first position to align the at least one hole with the at least one cooling channel to allow air flow through the at least one cooling channel and a second position to align the at least one hole with the at least one heating channel to allow air flow through the at least one heating channel.
Example 8: The thermal management system of example 7, wherein:
   the first position further blocks the at least one heating channel to restrict air flow through the heating channel; and
   the second position further blocks the at least one cooling channel to restrict air flow through the cooling channel.
Example 9: The thermal management system of example 8, wherein:
   the controller moves the at least one shutter to the first position based on a first temperature; and
   the controller moves the at least one shutter to the second position based on a second temperature.
Example 10: The thermal management system of example 1, wherein the at least one duct includes an equal number of cooling channels and heating channels in an alternating pattern.
Example 11: The thermal management system of example 1, wherein the at least one duct comprises:
   a side duct in thermal contact with a side wall of the at least one ESS, wherein the side duct includes at least one cooling channel and at least one heating channel; and
   a bottom duct in thermal contact with a bottom wall of the at least one ESS, wherein the bottom duct includes at least one cooling channel and at least one heating channel.
Example 12: The thermal management system of example 6, wherein the controller comprises:
   a control chamber comprising a diaphragm and a plunger, wherein the plunger moves the at least one shutter in response to a change in density of a heat sensing fluid;
   at least one heat sensing unit in thermal contact with the at least one ESS, wherein the at least one heat sensing unit comprises an enclosure for storing the heat sensing fluid; and
   at least one connection pipe to allow the heat sensing fluid to move between the at least one heat sensing unit and the control chamber in response to the change in density of the heat sensing fluid triggered by temperature changes of the at least one ESS.
Example 13: The thermal management system of example 1, wherein the at least one ESS comprises a battery.
Example 14: The thermal management system of example 1, wherein the at least one ESS comprises a fuel cell.
Example 15: The thermal management system of example 11, wherein:
   the at least one ESS comprises a plurality of ESS;
   the at least one heat sensing unit includes a plurality of heat sensing units; wherein each of the plurality of heat sensing units is in thermal contact with a respective ESS; and
   wherein at least one connection pipe interconnects the plurality of heat sensing units and the control chamber to facilitate movement of the heat sensing fluid in response to temperature changes across the plurality of ESS.
Example 16: The thermal management system of example 12, wherein the control chamber includes a spring for facilitating returning the plunger back to a neutral starting position.
Example 17: The thermal management system of example 12, wherein the heat sensing fluid is selected from a group consisting of freon, ammonia, an alcohol, hydrocarbons, a fluoridated liquid, a gallium alloy, a thermal oil, and carbon dioxide.
Example 18: The thermal management system of example 12, wherein the heat sensing unit, the at least one duct, the connection pipe, and/or the control chamber is constructed from a thermally conductive material.
Example 19: The thermal management system of example 18, wherein the thermally conductive material comprising at least one of copper, silver, or aluminum.
Example 20: The thermal management system of example 12, wherein density of the heat sensing fluid and temperature of the at least one ESS is inversely proportional.
Example 21: A method for performing thermal management for an energy storage system (ESS) of a vehicle:
   detecting, using a controller and a heat sensing fluid, changes in temperature of at least one ESS; and
   actuating, by the controller, a shutter positioned upstream of a duct to selectively control air flow through the duct, wherein the duct is in thermal contact with the at least one ESS, wherein the duct is internally shaped to heat incoming air when the vehicle is in motion.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A thermal management system for an energy storage system (ESS) of a vehicle comprising:
at least one ESS; and
at least one duct in thermal contact to the at least one ESS, wherein the at least one duct is internally shaped to heat incoming air when the vehicle is in motion.

2. The thermal management system of claim 1, wherein the at least one duct includes a heating channel comprising:
an acceleration region comprising:
a first inlet; and
a first convergent section downstream of the first inlet to accelerate air coming via the first inlet;
a primary heating region comprising:
a first divergent section downstream of first convergent section; and
a second convergent section downstream of divergent to build pressure upstream and accelerate air to hypersonic speed downstream; and

3. The thermal management system of claim 2, wherein the heating channel further comprises:
a secondary heating region comprising:
a throat section downstream of second convergent section to heat walls of the duct and to facilitate heat exchange of the air; and
an outlet downstream of the throat section.

4. The thermal management system of claim 3, wherein:
a first cross sectional area of the first inlet is larger than a second cross sectional area of the first convergent section;
a third cross sectional area of the first divergent section is larger than the second cross sectional area of the first convergent section; and
a fourth cross sectional area of the throat section is smaller than the second cross sectional area of the first convergent section.

5. The thermal management system of claim 2, wherein the at least one duct includes a cooling channel comprising:
a second acceleration region comprising:
a second inlet; and
a fourth convergent section downstream of the second inlet to accelerate air coming via the second inlet;
a low pressure region downstream of the fourth convergent section; and
an expansion region comprising:
a second divergent section downstream of the low pressure region to facilitate expansion, resulting in a temperature decrease of the air.

6. The thermal management system of claim 1, comprising:
at least one shutter positioned upstream of the at least one duct to selectively control air flow through the at least one duct; and
a controller for controlling the at least one shutter.

7. The thermal management system of claim 6, wherein:
the at least one duct includes at least one heating channel and at least one cooling channel; and
the at least one shutter includes at least one hole, wherein the shutter is adjustable between a first position to align the at least one hole with the at least one cooling channel to allow air flow through the at least one cooling channel and a second position to align the at least one hole with the at least one heating channel to allow air flow through the at least one heating channel.

8. The thermal management system of claim 7, wherein:
the first position further blocks the at least one cooling channel to restrict air flow through the cooling channel; and
the second position further blocks the at least one heating channel to restrict air flow through the heating channel.

9. The thermal management system of claim 8, wherein:
the controller moves the at least one shutter to the first position based on a first temperature; and
the controller moves the at least one shutter to the second position based on a second temperature.

10. The thermal management system of claim 1, wherein the at least one duct includes an equal number of cooling channels and heating channels in an alternating pattern.

11. The thermal management system of claim 1, wherein the at least one duct comprises:
a side duct in thermal contact with a side wall of the at least one ESS, wherein the side duct includes at least one cooling channel and at least one heating channel; and
a bottom duct in thermal contact with a bottom wall of the at least one ESS, wherein the bottom duct includes at least one cooling channel and at least one heating channel.

12. The thermal management system of claim 6, wherein the controller comprises:
a control chamber comprising a diaphragm and a plunger, wherein the plunger moves the at least one shutter in response to a change in density of a heat sensing fluid;
at least one heat sensing unit in thermal contact with the at least one ESS, wherein the at least one heat sensing unit comprises an enclosure for storing the heat sensing fluid; and
at least one connection pipe to allow the heat sensing fluid to move between the at least one heat sensing unit and the control chamber in response to the change in density of the heat sensing fluid triggered by temperature changes of the at least one ESS.

13. The thermal management system of claim 1, wherein the at least one ESS comprises a battery.

14. The thermal management system of claim 1, wherein the at least one ESS comprises a fuel cell.

15. The thermal management system of claim 12, wherein:
the at least one ESS comprises a plurality of ESS;
the at least one heat sensing unit includes a plurality of heat sensing units; wherein each of the plurality of heat sensing units is in thermal contact with a respective ESS; and
wherein at least one connection pipe interconnects the plurality of heat sensing units and the control chamber to facilitate movement of the heat sensing fluid in response to temperature changes across the plurality of ESS.

16. The thermal management system of claim 12, wherein the control chamber includes a spring for facilitating returning the plunger back to a neutral starting position.

17. The thermal management system of claim 12, wherein the heat sensing fluid is selected from a group consisting of freon, ammonia, an alcohol, hydrocarbons, a fluoridated liquid, a gallium alloy, a thermal oil, and carbon dioxide.

18. The thermal management system of claim 12, wherein the heat sensing unit, the at least one duct, the connection pipe, and/or the control chamber is constructed from a thermally conductive material.

19. The thermal management system of claim 18, wherein the thermally conductive material comprising at least one of copper, silver, or aluminum.

20. The thermal management system of claim 12, wherein density of the heat sensing fluid and temperature of the at least one ESS is inversely proportional.

21. A method for performing thermal management for an energy storage system (ESS) of a vehicle:
detecting, using a controller and a heat sensing fluid, changes in temperature of at least one ESS; and
actuating, by the controller, a shutter positioned upstream of a duct to selectively control air flow through the duct, wherein the duct is in thermal contact with the at least one ESS, wherein the duct is internally shaped to heat incoming air when the vehicle is in motion.
